# EUROPEAN PATENT APPLICATION

(11) **EP 3 878 531 A1**
(43) Date of publication of application: **15.09.2021**
(21) Application number: 21161829.3
(22) Date of filing: 10.03.2021
(51) Int. Cl.: A63F 13/28, G06F 3/01, G06Q 50/08, G06F 30/13, A63F 13/213, A63F 13/26

(54) **DEVICE, SYSTEM AND METHOD FOR IMMERSIVE VISUALIZATION IN A CUSTOMIZED ARCHITECTURAL SCENARIO**

(30) Priority: 12.03.2020 IT 202000005317
(71) Applicant: Ideadesign S.r.l., 00183 Roma (RM) (IT)
(72) Inventor: FOIS, Pierpaolo, I-00183 ROMA (RM) (IT); SBOCCHI, Devid, I-00183 ROMA (RM) (IT)
(74) Representative: Fiammenghi, Eva

(57) **Abstract**

Device for immersive visualization (10) in a customized architectural scenario, comprising:
- at least one internal screen (16) adapted to allow the visualization of an architectural environment previously designed by at least one user located inside said immersive visualization device (10);
- at least one audio speaker (14) adapted to play sounds and/or melodies which accompany the user in the virtual exploration of the designed space;
- at least one odor diffuser (15) adapted to emit odors in accordance with what is displayed on said at least one internal screen (16);
- at least one video camera (20) adapted to frame the internal space of said immersive visualization device (10), detecting the user's movements and the direction of his/her gaze;
- at least one workstation (19) comprising at least one housing for at least one virtual reality viewer (30).

## Description

### Field of the invention

The present invention relates to the field of immersive visualization systems and methods, with virtual reality technology. This particular sector is associated, in the context of the present invention, with architecture and interior design, allowing a user to view his/her own designed space in an immersive and interactive manner, being able to request changes in real time.

### Prior art

Renovating or designing a house or any other environment in which to live is known to be one of the most stressful and uncertain-outcome processes a person can face. The design of the spaces still presents major gaps that lead to a final result that is often completely different or unexpected for those who will use those spaces.

This is due to the fact that the projects proposed on paper (two-dimensional) are difficult to understand for non-experts (therefore people who are not engineers, architects, surveyors, designers, etc.) and sometimes also for technicians, especially in the management of some details. Whether the project concerns a villa, a boat or a shopping center, with its two-dimensional designs it is almost impossible to verify the spaces and their ergonomic dimensions, both inside and outside.

Another problem lies in the samples of the materials that a user can choose as cladding or flooring. Hardly anyone is able to imagine them on a large surface and understand exactly what the final aesthetic effect will be. For this reason, very often we move towards "safe" choices, sober, neutral colors and materials already seen in other spaces, to avoid making serious errors of evaluation.

All this contributes to the feeling of disorientation of those who have to renovate their homes or choose the best furnishing solutions. All the confusion of customers can also lead to the dispute of the unwelcome final result for which the blame is placed on the designer and the consultant who guided the choice of materials.

Even showrooms and design studios, in order to try to convey the idea of the result to the customer, should be very large and with an enormous amount of material samples, with the consequence of having to incur huge maintenance costs and being able to choose among few locations that have sufficient square meters.

The same Applicant is already the holder of a patent application concerning a technological helmet and an associated kit thanks to which a user can have an immersive preview of the space in the design step.

Although thanks to the technology described in the aforesaid patent application it is possible to solve some of the problems encountered, the engineering of the helmet is complex and expensive. Furthermore, the user of the helmet and the other components of the kit will have to wear this bulky equipment which for some is disturbing. Furthermore, virtual reality becomes a disturbance for the senses for many users, precisely because of its immersive nature. In fact, many users have experienced loss of balance, headaches and nausea.

Therefore, the object of the invention is to propose an immersive visualization technology that is less invasive than that of the viewer and the helmet, also proposing a plurality of functional areas and a relative method of use that concur to provide a user with a realistic preview of a customized architectural space.

### Description of the invention

According to the present invention, a device is implemented, included in a system and an associated method for immersive visualization which effectively solve the above problems.

The device, or the central element of the present invention, consists of a closed volume, preferably cylindrical, accessible through a common door. It contains at least one user station consisting of a signal on the ground in which the presence of the user who intends to live the immersive visualization experience is recommended.

The technology included in the immersive visualization device includes:
- at least one screen placed at a wall within the volume, where the user can view the previously designed architectural environment, internal or external;
- at least one audio speaker adapted to play sounds and/or melodies which accompany the user in the virtual exploration of the designed space;
- at least one odor diffuser capable of emitting odors in accordance with what is displayed on the screen. This function is particularly advantageous when viewing outdoor spaces, such as gardens, terraces, parks, urban environments;
- at least one video camera adapted to frame the internal space of said immersive visualization device, detecting the user's movements and the direction of his/her gaze. This feature is particularly useful for two reasons: the first is for safety, in the event that the user is alone in the visualization device, to prevent him/her from falling ill or damaging the equipment present. The second reason is technological. In a particularly advantageous embodiment, in fact, the user's virtual walk can be aided by an image analysis software, integrated in the cameras, adapted to recognize where the user wants to go in the virtual space, according to the movements of his/her body, his/her head and the direction of his/her gaze. Such a virtual walk is also advantageously supported by any vocal instructions that the audio speakers can emit, to teach the user how to change the point of view displayed on said screen;
- at least one workstation comprising at least one housing for at least one virtual reality viewer. Such a viewer can be worn or not, depending on the user's preferences. If it is worn, the presence of at least one operator inside the immersive visualization device is preferable.

Other advantageous features that can be included in the visualization device in question may be:
- a scanner device placed at the external surface of the device. This is advantageously adapted to allow the recognition of a unique code associated with a specific project and therefore the visualization, within the device, of that specific architectural project;
- at least one screen placed on at least one external surface;
- a movable platform, placed at said station for the user who uses virtual reality. Said movable platform is advantageously configured to allow the user to move, that is to really walk as on a treadmill, causing movement also in the virtual space that is being viewed;
- a temperature regulation device adapted to modify the internal temperature of said immersive visualization device, raising or lowering it according to the visualized virtual spaces;
- a signaling light placed on at least one external surface, adapted to signal the fact that the device is occupied by another user;
- a pair of tactile gloves, available in the same position as the viewer, adapted to transmit to the user who is living the experience of immersive visualization, also the sensation of touching objects in the designed architectural space. Furthermore, the tactile gloves are advantageously provided with suitable sensors adapted to allow the display of the user's hands in the virtual scene.

It is clear that such a device leaves room for numerous possibilities of use, all equally advantageous, to have a realistic preview of the space that will be lived and therefore solving the problems still related to the prior art.

The advantages so far evident may be further enhanced in the various embodiments in which the immersive visualization device described above is integrated into a system of functional areas comprising at least:
- a reception area in which to receive the user and lay the foundations of the architectural and/or landscape project;
- an exhibition area where the user can select the materials and finishes to be included in his/her architectural and/or landscape project;
- a consultation area of furnishings, finishes, coatings and accessories on digital catalogs, where the user can select elements to be included in his/her architectural and/or landscape project using suitable electronic devices;
- a private area where the user can approve the project just viewed and define the last details with a dedicated operator;
- a possible technical area provided with services, warehouse, devices for network connection of all areas such as central server and Wi-Fi router.

In the preferred embodiment, the system included in the present invention comprises the immersive visualization device provided with a scanner. Similar fixed or portable scanners will be advantageously installed in all other functional areas. In this way, by scanning a unique code previously associated with a specific project, the user, in complete autonomy, can select and/or modify the materials, finishes, coatings, furnishings and furnishing accessories of his/her specific architectural project, then verifying the result within the immersive visualization device.

In particular, the area where the materials are exhibited will be provided with an optical scanner with which to scan the unique code associated with each exhibited material. In this way, each user can independently select the preferred materials and insert them in real time in his/her project.

The advantages offered by the present invention are clear in the light of the above description and will be even clearer from the accompanying figures and the related detailed description.

### Description of the figures

The invention will hereinafter be described in at least one preferred embodiment thereof by way of non-limiting example with the aid of the accompanying figures, in which:
- FIGURE 1 shows a three-dimensional and schematic view of the immersive visualization device 10 which constitutes the fulcrum of the present invention.
- FIGURE 2 illustrates one of the possible distributions of the functional spaces that make up the project customization system 100 centered on the immersive visualization device 10.

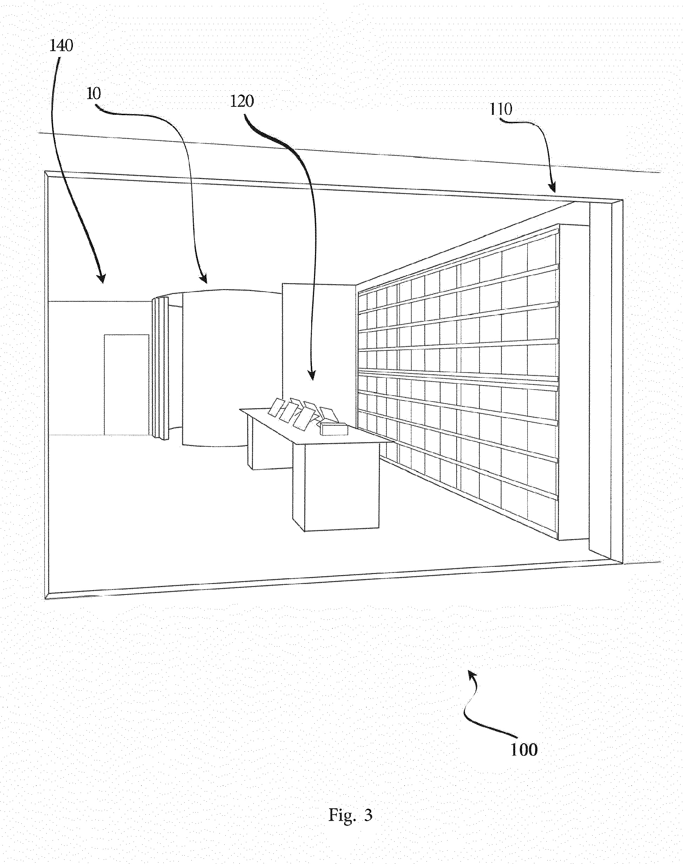

- FIGURE 3 shows a three-dimensional view of some of the functional spaces of the previous figure 2.

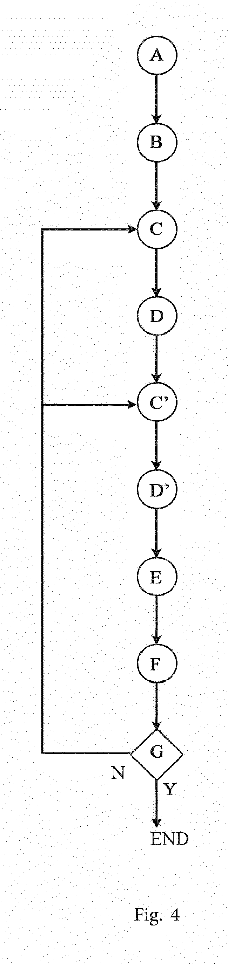

- FIGURE 4 schematizes the flow chart underlying the customization method of an architectural project included in the present invention.

### Detailed description of the invention

The present invention will now be described purely by way of non-limiting or binding example with the aid of the figures, which illustrate some embodiments relative to the present inventive concept.

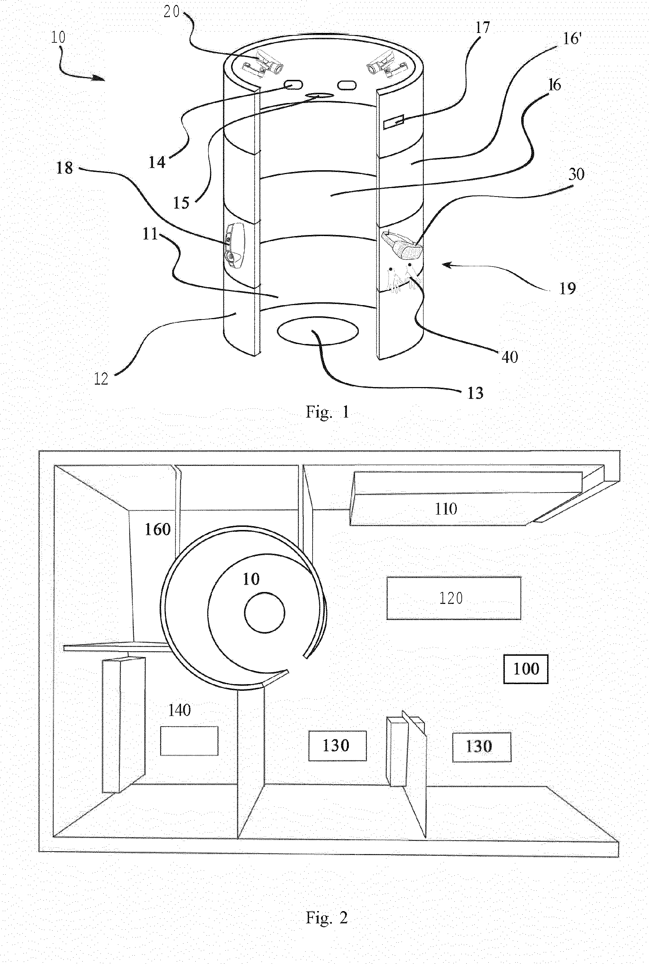

With reference to FIG. 2, the preferred layout, among the various possible ones, for a point of sale which exploits the advantages of the present invention is shown.

As previously mentioned, the preferred embodiment of the present invention allows a user to select in complete autonomy the materials, finishes, coatings and furnishings of the space where he/she will live or that will use in the future in the design step.

This possibility is allowed by a method that includes the following steps:
(A) preparing a three-dimensional model of the architectural space by a dedicated professional. This step may be carried out remotely or at a specific consultancy area 130 set up within the system 100 of functional areas;
(B) assigning a unique code to the project and transmitting said unique code to the user via paper device or via smartphone software application;
(C) scanning the unique code at a scanner 18 installed in said exhibition area 110 and consequently loading the previously elaborated three-dimensional model;
(D) selecting materials on an electronic device installed in the exhibition area 110 for the various components and surfaces of the previously loaded three-dimensional model; such a selection takes place by scanning a unique code previously associated with the material selected by the user using a portable reader provided at said exhibition area 110;
(C') possibly scanning the unique code again at a scanner 18 installed at a consultation area 120 and subsequent loading the previously elaborated three-dimensional model already showing the finishes selected in the previous step D;
(D') possibly selecting materials on an electronic device installed in consultation area 120 for the various components and surfaces of the previously loaded three-dimensional model; the selected materials and furnishings will be immediately loaded into the project file;
(E) scanning said unique code at the scanner device 18 of said immersive visualization device 10;
(F) entering into said immersive visualization device 10, possibly together with an operator, and visualizing the architectural space designed on the screen 16 or through the viewer 30, with the finishes, materials, furnishings and everything previously selected. Possibly, for easier movement in the virtual architectural space, a dedicated joystick may be used or the voice instructions emitted by the audio speaker 15 must be followed;
(G) user exiting from the immersive visualization device 10 and project evaluation:
   - in the event that the project just viewed was approved, the user will conclude the economic details at the private area 140 with a dedicated operator;
   - in the event that the project is not approved, the user will return to said exhibition area 110 or said consultation area 120, scanning the unique code associated with his/her project again, to make changes or additions to the project.

Finally, in the version considered, to date, the best possible for carrying out the method included in the present invention, the user may be made even more autonomous through a step of providing a portable electronic device dedicated to carrying out the method in the system 100 of functional areas for the immersive visualization of a customized architectural space. Such an electronic device will be configured with a dedicated software application to avoid the need for the user to be assisted by a dedicated operator or consultant.

The device, the system and the method of the present invention are adapted to display and modify both indoor and outdoor projects, with the same methods and the same advantages. Finally, it is clear that modifications, additions or variants that are obvious to a person skilled in the art can be made to the invention described so far, without thereby departing from the scope of protection provided by the appended claims.

## Claims

1. Device (10) for immersive visualization in a customized architectural scenario, adapted to allow at least one user to preview any designed environment, customizing the finishes, coatings and furnishings thereof, said device (10) being **characterized in that** it consists of a closed volume, accessible through an access door, provided with at least one internal surface (11) and at least one external surface (12), said internal surface (11) surrounding at least one user station (13) consisting of a signal on the ground in which the presence of the user who intends to live the immersive visualization experience is recommended; said device (10) comprising:
- at least one internal screen (16) adapted to allow the visualization of an architectural environment previously designed by at least one user located inside said immersive visualization device (10);
- at least one audio speaker (14) adapted to play sounds and/or melodies which accompany the user in the virtual exploration of the designed space;
- at least one odor diffuser (15) adapted to emit odors in accordance with what is displayed on said at least one internal screen (16);
- at least one video camera (20) adapted to frame the internal space of said immersive visualization device (10), detecting the user's movements and the direction of his/her gaze;
- at least one workstation (19) comprising at least one housing for at least one virtual reality viewer (30).

2. Device (10) for immersive visualization in a customized architectural scenario, according to the preceding claim 1, **characterized in that** it comprises at least one scanner device (18), fixed or portable, placed at an external surface (12) of said device (10); said scanner (18) allowing the recognition of a unique code associated with a specific project and therefore the visualization, within the device (10), of that specific architectural project.

3. Device (10) for immersive visualization in a customized architectural scenario, according to any one of the preceding claims 1 or 2, **characterized in that** it comprises at least one external screen (16'), placed on at least one external surface (12), adapted to allow the visualization of the designed architectural scenario from outside the device (10).

4. Device (10) for immersive visualization in a customized architectural scenario, according to any one of the preceding claims, **characterized in that** it comprises at least one signaling light (17) placed on at least one external surface (12), adapted to signal the fact that the device (10) is occupied or not by another user.

5. Device (10) for immersive visualization in a customized architectural scenario, according to any one of the preceding claims, **characterized in that** said workstation (19) comprises at least one housing for at least one pair of tactile gloves (40) adapted to transmit to the user that is living the experience of immersive visualization, also the sensation of touching objects in the designed architectural space; said tactile gloves (40) being provided with suitable sensors adapted to allow the display of the user's hands in the virtual scene.

6. Device (10) for immersive visualization in a customized architectural scenario, according to any one of the preceding claims, **characterized in that** it comprises a movable platform, placed at said workstation (19) adapted to allow said user to move, or actually walk like on a treadmill, determining movement also in the virtual space being visualized.

7. Device (10) for immersive visualization in a customized architectural scenario, according to any one of the preceding claims, **characterized in that** it comprises a temperature regulation device adapted to modify the internal temperature of said immersive visualization device raising or lowering it according to the visualized virtual spaces.

8. System (100) for immersive visualization in a customized architectural scenario, **characterized in that** it comprises:
- at least one immersive visualization device (10) according to any one of the preceding claims;
- at least a reception area (130) in which to receive the user and lay the foundations of the architectural project;
- at least one exhibition area (110) where the user can select the materials and finishes to be included in his/her architectural project;
- at least one consultation area (120) of furnishings, finishes, coatings and accessories on digital catalogs, where the user can select elements to be included in his/her architectural project;
- at least one private area (140) where the user can approve the project just viewed and define the last details with a dedicated operator.

9. System (100) for immersive visualization in a customized architectural scenario, according to the preceding claim 8, **characterized in that** in each area (110-120-130-140-10) there are fixed or portable scanner devices (18), adapted to recognize a unique code associated with a specific project and therefore the possibility of selecting and/or modifying the materials, finishes, coatings, furnishings and furnishing accessories of that specific architectural project, then checking the result within the immersive visualization device (10).

10. System (100) for immersive visualization in a customized architectural scenario, according to any one of the preceding claims 8 or 9, **characterized in that** it comprises a technical area (160) provided with services, warehouse, devices for network connection of all areas (110-120-130-140-10) such as central server and Wi-Fi router.

11. Method of immersive visualization in a customized architectural scenario, adapted to allow at least one user to preview any designed environment, customizing the finishes, coatings and furnishings thereof, said method being **characterized in that** it takes place in a system (100) of functional areas according to the preceding claim 9 and **in that** it comprises the steps of:
(A) providing a three-dimensional model of the architectural space by a dedicated professional; said project being preferably agreed upon at said reception and consultation area (130);
(B) assigning a unique code to the project and transmitting said unique code to the user via paper device or via smartphone software application;
(C) scanning said unique code at one of the scanners (18) installed in said exhibition area (110) and consequently loading the previously elaborated three-dimensional model;
(D) selecting materials on an electronic device installed in the exhibition area (110) for the various components and surfaces of the previously loaded three-dimensional model; such a selection takes place by scanning a unique code previously associated with the material selected by the user using a portable scanner (18) provided at said exhibition area (110);
(C') possibly scanning said unique code at one of the scanners (18) installed in said consultation area (120) and consequently loading the previously elaborated three-dimensional model;
(D') possibly selecting the materials on an electronic device installed in the consultation area (120) for the various components and surfaces of the previously loaded three-dimensional model;
(E) scanning said unique code at the scanner device (18) of said immersive visualization device (10);
(F) entering into said immersive visualization device (10) and visualizing the architectural space designed, with the finishes, materials, furnishings and everything previously selected; said user moving within said virtual architectural space through a dedicated joystick or by executing the voice instructions emitted by at least one audio speaker (15);
(G) user exiting from the immersive visualization device (10) and project evaluation:
- in the event that the project just viewed was approved, said user will conclude the economic details at said private area (140) with a dedicated operator;
- in the event that the project is not approved, the user will return to said exhibition area (110) or said consultation area (120), scanning the unique code associated with his/her project again, to make changes or additions to the project.

12. Method of immersive visualization in a customized architectural scenario, according to the preceding claim 11, **characterized in that** it comprises a step of providing a portable electronic device to said user who enters the system (100) of functional areas according to the preceding claim 9; said portable electronic device being configured with a software application dedicated to carrying out the method according to the preceding claim 11 by the user, in complete autonomy, without the support of a dedicated operator or consultant.
